# EUROPEAN PATENT SPECIFICATION

(11) **EP 0 601 703 B1**
(45) Date of publication and mention of the grant of the patent: **15.01.1997**
(21) Application number: 93308526.8
(22) Date of filing: 26.10.1993
(51) Int. Cl.: H05K 7/14, H01R 4/48

(54) **Mounting bracket for an electrical connector**
Haltevorrichtung für einen elektrischen Verbinder
Support pour le montage d'un connecteur électrique

(30) Priority: 08.12.1992 US 986660; 08.12.1992 US 987225
(43) Date of publication of application: 15.06.1994
(73) Proprietor: THE WHITAKER CORPORATION, Wilmington, Delaware 19808 (US)
(72) Inventor: Kaufman, John Wilson, Hershey, Pennsylvania 17033 (US); Broschard, John Lawrence III, Harrisburg, Pennsylvania 17111 (US); Woratyla, John Anthony, Camp Hill, Pennsylvania 17011 (US); Brennian, Ronald Wolff, Jr., Columbia, Pennsylvania 17512 (US); Correll, Robert Stewart, Jr., Harrisburg, Pennsylvania 17111 (US); Fortuna, Jon Alan, Mechanicsburg, Pennsylvania 17055 (US)
(74) Representative: Warren, Keith Stanley

(56) References cited:
- DE-U- 8 704 410
- DE-U- 9 217 302
- US-A- 4 952 161
- US-A- 5 033 972
- US-A- 5 171 165

## Description

The invention relates to a mounting bracket for an electrical connector for a card reader and, more particularly, to a mounting bracket for an electrical connector having guide arms for guiding a card into the connector.

A known electrical connector, disclosed in US-A-4,952,161 comprises a card connector having card guide grooves for guiding two cards in an overlapping manner. It would be desirable to adapt such a card connector for mounting to either one of a first circuit board or a second, inverted circuit board.

The present invention consists in a mounting bracket for an electrical connector including a housing, a card receiving mouth in the housing, electrical contacts carried by the housing in the mouth, prong receiving sockets on the housing, guide arms on opposite sides of the mouth, a card receiving groove on each of the guide arms, and a prong on each of the guide arms constructed for locking engagement with the sockets, characterised in that the mounting bracket is engageable in a selected channel in the housing and guide arms and comprises at least one arm projecting from a base, which provides for connection to a circuit board, projections on the or one of the arms, and a hold down finger extending laterally in the plane of the or one of the arms, the mounting bracket being slidable in the selected channel with the projections biasing the arm or the arms against opposite sides of the channel, the channel being widened at opposite ends to provide a first ledge and a second inverted ledge at the ends, respectively, and the hold down finger overlapping a selected one of the first ledge and the inverted ledge to position the base in a first non-inverted position or in a second, inverted position.

Embodiments of the invention will now be described by way of example with reference to the accompanying drawings in which:-
FIGURE 1 is a perspective view of an electrical connector having a housing and a set of card guide arms for a single card, together with mounting brackets according to the invention and a circuit board;
FIGURE 2 is a perspective view of an assemblage of the devices shown in Figure 1;
FIGURES 3, 4, 5 and 6 are perspective views of mounting brackets;
FIGURES 7 and 8 are fragmentary elevation views illustrating the mounting bracket of Figure 3 in the process of connection with a portion of the housing shown in Figure 1;
FIGURE 9 is a fragmentary perspective view of a taller housing and a set of taller card guide arms, together with taller mounting brackets;
FIGURES 10 and 13 are views similar to Figures 7 and 8, and illustrate the mounting bracket of Figure 5 in the process of connection with a portion of the housing shown in Figure 1;
FIGURES 11 and 12 are fragmentary bottom views of the devices shown in Figures 10 and 13, respectively;
FIGURE 14 is a fragmentary enlarged view of the housing of Figure 1 stacked together with a duplicate housing, and a mounting bracket mounted to a circuit board;
FIGURE 15 is an enlarged perspective view of the mounting bracket as shown in Figure 14; and
FIGURE 16 is an enlarged fragmentary view of the stacked housings and an inverted mounting bracket mounted to a second circuit board.

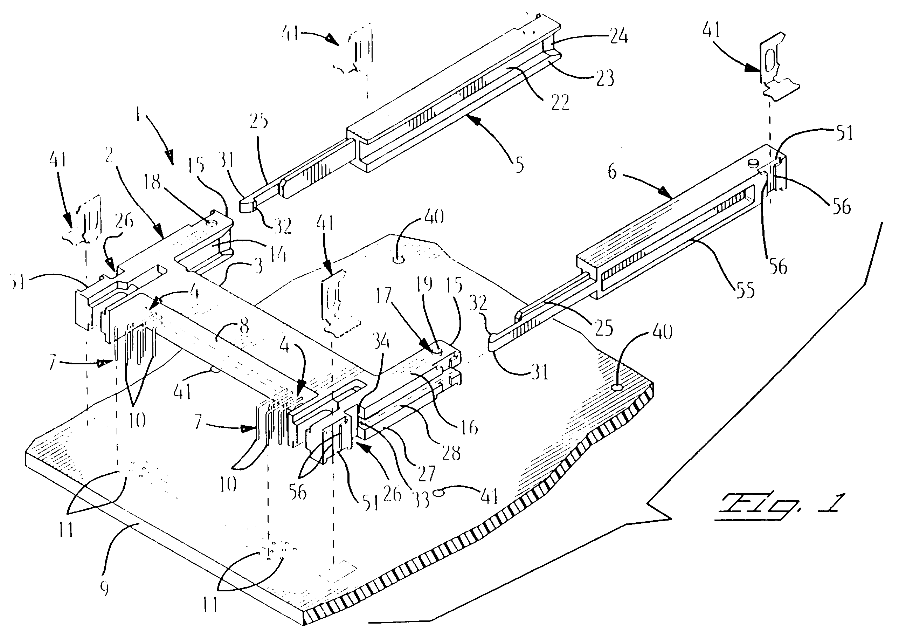

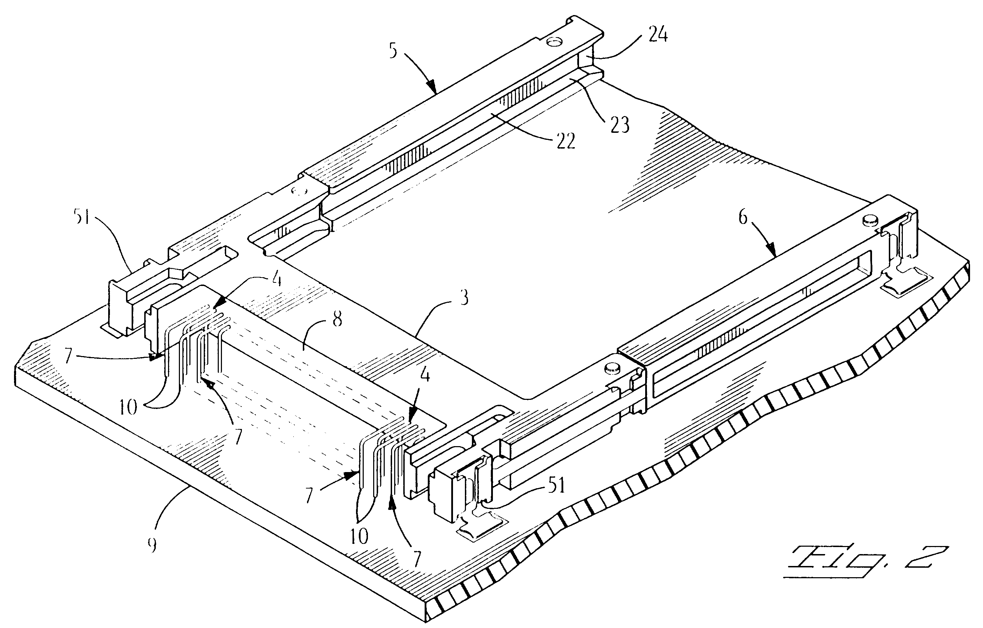

With reference to Figures 1 and 2, an electrical connector 1, especially suitable for use in a card reader, not shown, includes an insulating housing 2 having a card receiving mouth 3 multiple electrical contacts 4 held by the housing 2 extending in two rows and into the mouth 3, and a set of card guide arms 5, 6. Tail sections 7 of the contacts 4 extend outwardly of a rear surface 8 of the housing 2 for connection to a first circuit board 9 shown in phantom outline. Feet 10 on free ends of the contacts 4 are adapted with respective shapes for connection to the circuit board 9. For example, the feet 10 are shaped as posts for insertion into plated apertures 11 of the circuit board 9. Alternatively, the feet 10 can be shaped as surface mount flat portions, not shown, for connection to surface mount pads on the circuit board 9.

With reference to Figures 14 and 16, the connector 1 is accompanied by a duplicate housing 2, inverted, and by another set of inverted guide arms 5,6, not shown. A bottom surface **12** is on each housing 2 with a projecting knob or foot **13** received in an alignment aperture **40** in the circuit board 9. Each housing 2 has starter grooves **14** in forwardly projecting housing arms **15** on opposite sides of the mouth 3. A top surface **16** of each housing 2 has a locking structure **17** in the form of a recess **18** on one side flanking the mouth 3, and a projecting knob **19** in another side flanking the mouth 3. The duplicate housings 2 can be stacked and interlocked, Figures 14 and 16, when inverted with respect to each other, with the recess 18 of each housing receiving the knob 19 of the other housing.

Each housing 2 is constructed for use alone on the circuit board 9, Figures 1 and 2, or for interlocking with a duplicate housing 2, Figures 14 and 16. The card receiving mouth 3 is defined either by a single housing 2 or by two housings 2. The card receiving mouth 3 is adapted to receive one or, alternatively, two cards, one for each of the stacked housings 2. The cards are known in the industry, and are disclosed, for example, in U.S.A. 5,033,972.

With reference to Figure 16, the stacked housings 2 can be mounted to a second, inverted circuit board 9, as an alternative to the first circuit board 9, as shown in Figure 1.

The guide arms 5, 6 are of unitary construction molded from a thermoplastic material. As shown in Figure 1, card receiving grooves **22** on inside surfaces **23** extend along lengths of the respective guide arms 5, 6. Flared, groove mouths **24** at respective ends of the guide arms 5, 6 open into respective grooves 22 of the guide arms 5, 6. At opposite ends of respective guide arms 5, 6, respective elongated prongs **25** extend outwardly.

The prongs 25 lockingly engage in sockets **26**, the sockets 26 being in respective, exterior side surfaces **27** of the housing 2 flanking the mouth 3. The prongs 25 have respective cross sections that interfit slidably along grooves **28** in the respective, exterior side surfaces 27 of the housing 2. Ends of the prongs 25 have respective locking latches 31 with transverse, projecting fingers **32**. The fingers 32 are forced to bend resiliently as they traverse in respective grooves 28, until the fingers 32 emerge from ends 33 of the grooves 28 and unbend to register against transverse latch shoulders **34** at the ends 33 of the grooves 28. Thereby, the prongs 25 lockingly engage the sockets 26.

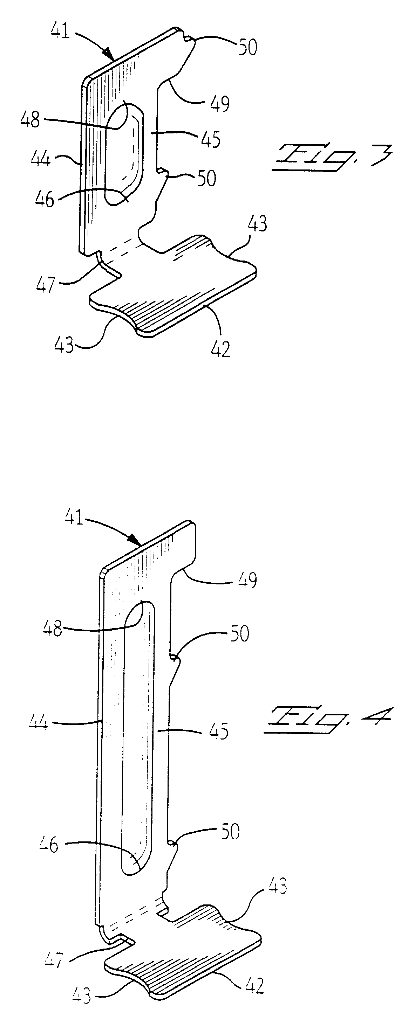

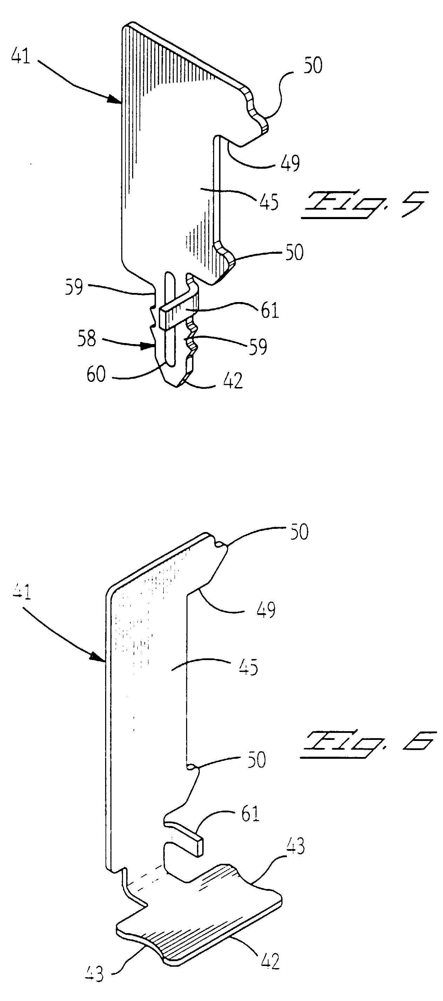

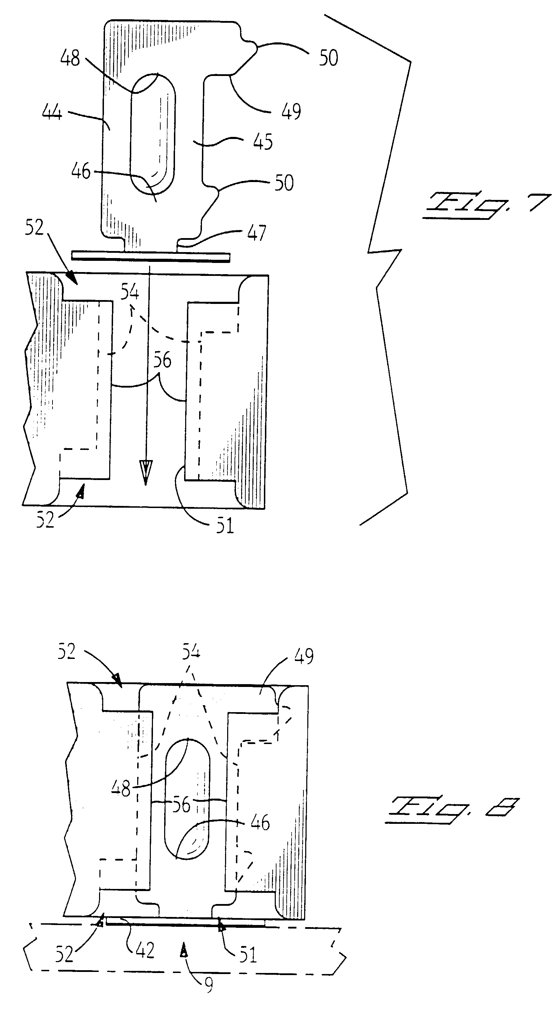

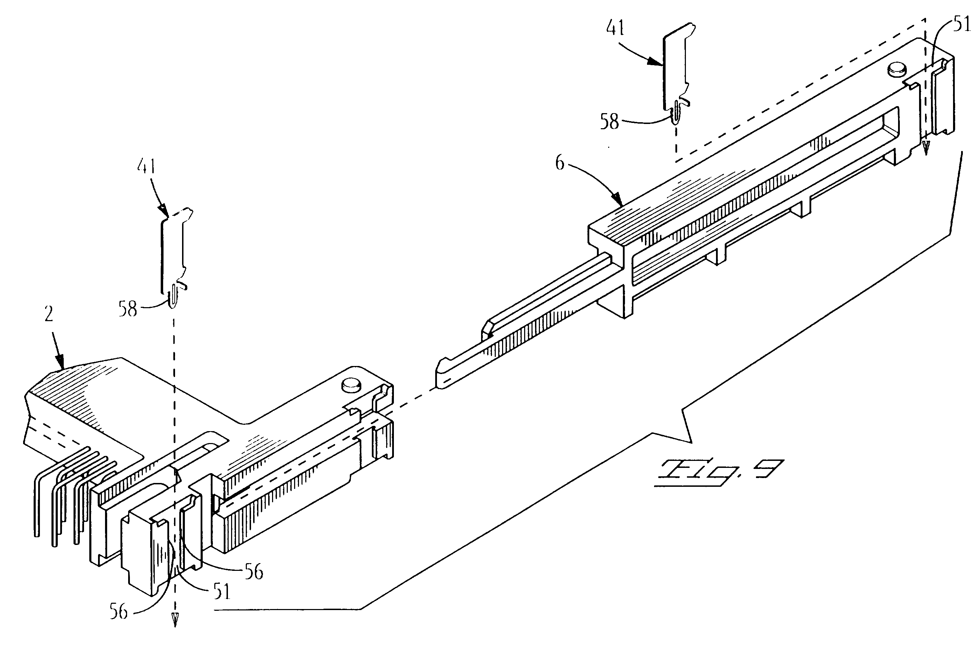

With reference to Figures 3 through 6, a mounting bracket **41** of varied constructions will be described. The mounting bracket 41, of unitary construction, is stamped and formed from a strip of metal and comprises a flat base **42** and at least one arm **45** projecting from the base. A hold down finger **49** extends laterally from the arm 45 in the thickness plane. Also in the thickness plane, a pair of wedge shaped projections **50** are spaced apart along the same arm 45 and extend laterally in the same direction as the hold down finger 49. With reference to Figures 3, 5 and 6, one of the projections 50 projects from the finger 49, and one of the projections 50 projects from the arm 45. With reference to Figures 4, both projections 50 project from the arm 45.

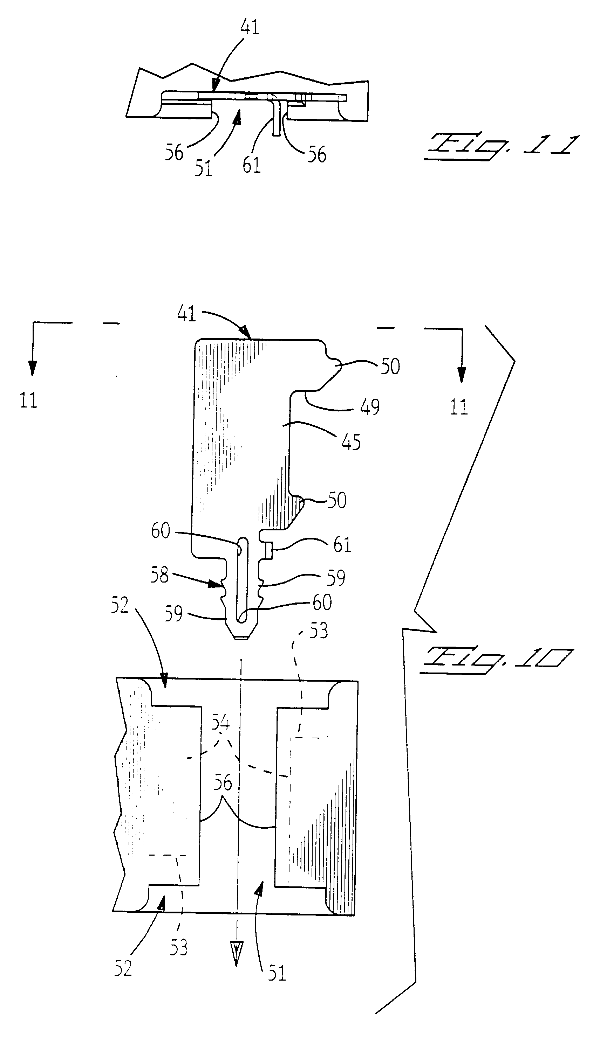

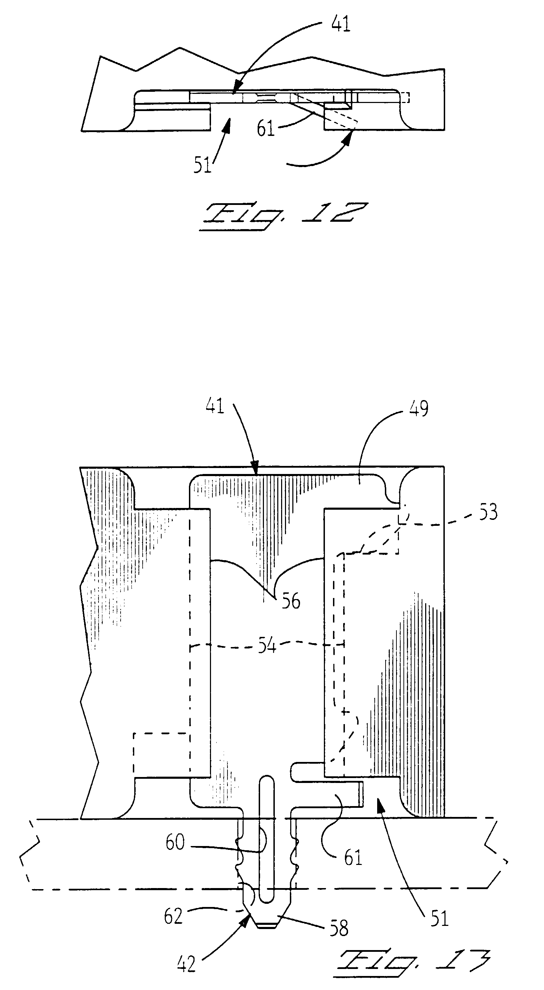

With reference to Figures 3, 4, 7, 8 and 15, a pair of coplanar arms **44**, 45 project from the base 42. The arms 44, 45 are joined by a first bight **46** joined to the base 42 by a thin, strain relieving, web **47** that is bendable when forces are applied to the arms 44, 45 to prevent transfer of the forces to the base 42, and thereby prevent the forces from dislodging the base 42 from its solder connection. A second bight **48** bridges remote ends of the arms 44, 45.

The base 42 of Figures 3, 4 and 15 is bent to extend transverse to the thickness plane of the arms 44, 45. The base 42 of Figures 3, 4, 6 and 15 has serpentine shaped edges 43 of serpentine lengths adapted to be wetted by molten solder, not shown, for solder connection of the base 42 to a conductive pad of the circuit board 9, Figures 1, 2 and 8, or the inverted circuit board 9, Figure 16.

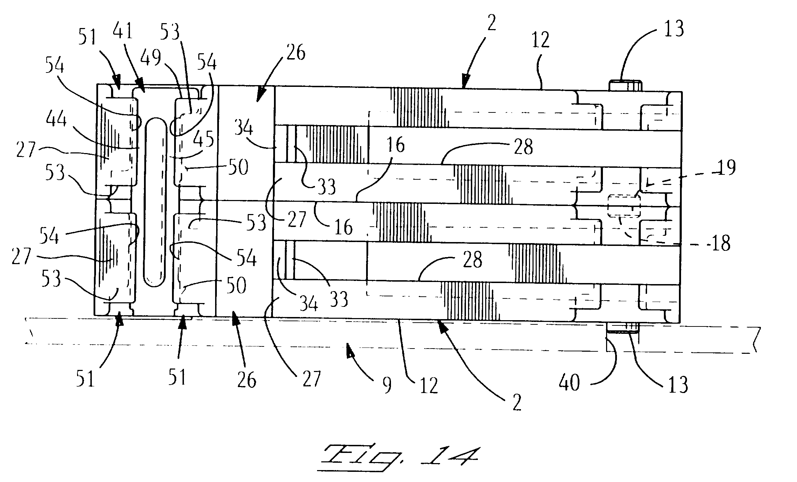

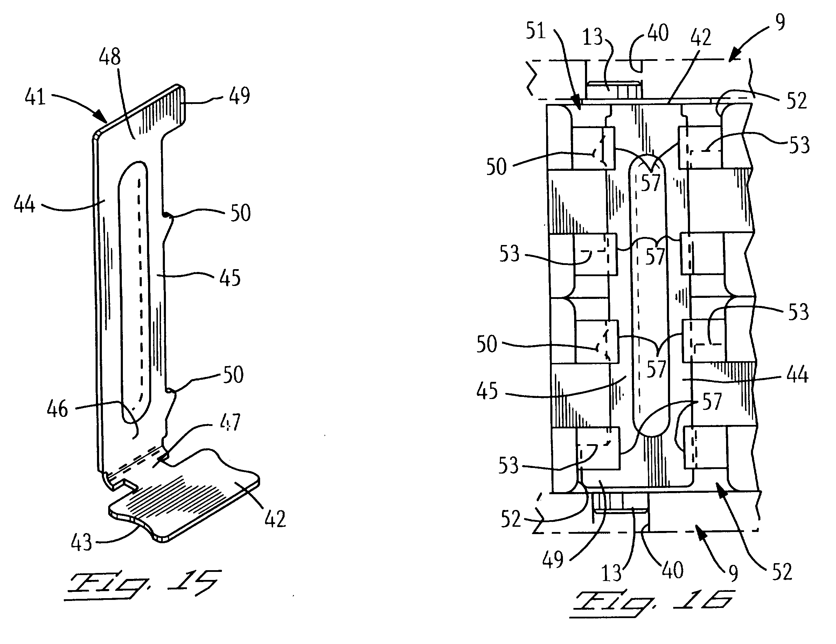

With reference to Figures 1, 2, 7, 8, 9, 10, 13, 14 and 16, the mounting bracket 41 is inserted along one of multiple channels **51** recessed in each of the side surfaces 27 of the housing 2. Each of the channels 51 is widened at opposite, open ends **52** to provide recessed ledges **53** in opposite sides **54** of the channel 51, with one of the ledges 53 being inverted. The hold down finger 49 overlaps the ledge 53 to hold the housing 2 against the first circuit board 9. With reference to Figure 16, the mounting bracket 41 is inverted, such that the hold down finger 49 overlaps the inverted ledge 53 while the base 42 is solder connected to a pad, not shown, on the inverted circuit board 9, and the inverted foot 13 of the stacked housing 2 is received in an aperture 40 of the inverted circuit board 9. The projections 50 of the mounting bracket 41 wedge against a side 54 of the channel, and resiliently deflect the arm 45, such that the arms 44, 45 frictionally engage the opposite sides 54 of the channel 51.

A channel 51 of similar construction is recessed in an exterior side **55** of each guide arm 5, 6, Figures 1, 2 and 9. Each of the channels 51 in the guide arms 5,6, and in the housings 2, is constructed with the two open ends 52 and the two ledges 53 to receive a mounting bracket 41 in an inverted position for solder connection of the mounting bracket 41 to the inverted circuit board 9 or, alternatively, to receive a mounting bracket 41 in a non-inverted position for solder connection to the first circuit board 9.

With reference to Figures 1, 7, 8, 9, 10, 13 and 14, flanges **56** overhang opposite sides 54 of each channel 51, to overlap edges of the arms 44, 45 of a mounting bracket 41 in the channel 51. One set of the flanges 56 on each side 55 of the housing 2 is divided into spaced apart segments **57**, Figure 16. Each of the flanges 56 overlies a portion of the hold down finger 49 and the projections 50 to maintain them in the plane of thickness of the mounting bracket 41.

The base of the mounting bracket of Figures 5, 9, 10 and 13 is a barbed, slotted post **58** defined by two barbed spring members **59** extending along opposite sides of a slot **60** having closed ends that join the spring members 59 together. Further details of the post 58 are disclosed in U.S. A. 4,907,987. The post 58 is adapted for insertion in an aperture **69** of the circuit board 9, Figure 13, instead of a pad as in the circuit board of Figures 1, 2, 8, 14 and 16.

A second finger 61 on the base 42 at an end of the arm 45 remote from the finger 49 is bent out of the plane of the arm 45, Figures 5, 6, 10 and 11, to pass between the spaced apart flanges 56, as the base 42 and the arm 45 are inserted along the channel 51. The second finger 61 is thereafter bent to return toward the plane of the arm 45, Figures 12 and 13, and to project laterally in the same direction as the finger 49, and to overlap a corresponding, recessed end of the channel 51. The ledge 53 and the recessed end of the channel 51 are interposed between the fingers 49, 61, Figure 13, thereby to retain the mounting bracket 41.

## Claims

1. A mounting bracket for an electrical connector (1) including a housing (2), a card receiving mouth (3) in the housing, electrical contacts (4) carried by the housing in the mouth, prong receiving sockets (26) on the housing, guide arms (5,6) on opposite sides of the mouth, a card receiving groove (22) on each of the guide arms, and a prong (25) on each of the guide arms constructed for locking engagement with the sockets, characterised in that the mounting bracket (41) is engageable in a selected channel (51) in the housing and guide arms and comprises at least one arm (44,45) projecting from a base (42), which provides for connection to a circuit board, projections (50) on the or one of the arms, and a hold down finger (49) extending laterally in the plane of the or one of the arms, the mounting bracket being slidable in the selected channel with the projections biasing the arm or the arms against opposite sides (54) of the channel, the channel being widened at opposite ends (52) to provide a first ledge (53) and a second inverted ledge (53) at the ends, respectively, and the hold down finger overlapping a selected one of the first ledge and the inverted ledge to position the base in a first non-inverted position or in a second, inverted position.

2. A mounting bracket as recited in claim 1 for an electrical connector comprising a stacked pair of the housings and guide arms having channels (51) thereof aligned to receive a single such mounting bracket, wherein the projections on the mounting bracket are engageable in sides of respective aligned channels of the stacked housings and guide arms.

## Patentansprüche

1. Haltevorrichtung für einen elektrischen Verbinder (1) mit einem Gehäuse (2), einer Kartenaufnahmemündung (3) in dem Gehäuse, mit von dem Gehäuse getragenen elektrischen Kontakten (4) in der Mündung, Aufnahmebuchsen (26) für Zinken an dem Gehäuse, Führungsarmen (5, 6) an entgegengesetzten Seiten der Mündung, einer Kartenaufnahmenut (22) an jedem der Führungsarme und einem Zinken (25) an jedem der Führungsarme, der zum Verriegelungseingriff mit den Buchsen konstruiert ist, **dadurch gekennzeichnet**, daß die Haltevorrichtung (41) in einen ausgewählten Kanal (51) in dem Gehäuse und in den Führungsarmen einsetzbar ist und wenigstens einen Arm (44, 45) aufweist, der von einem Unterteil (42) vorragt, der für eine Verbindung mit einer Schaltungsplatte bestimmt ist, mit Vorsprüngen (50) an dem Arm oder an einem der Arme, und mit einem Niederhaltefinger (49), der sich seitlich in der Ebene des Arms oder eines der Arme erstreckt, wobei die Haltevorrichtung in dem ausgewählten Kanal verschiebbar ist, wobei die Vorsprünge den Arm oder die Arme gegen gegenüberliegende Seiten (54) des Kanals vorbelasten, wobei der Kanal an entgegengesetzten Enden (52) erweitert ist, um eine erste Leiste (53) und eine zweite umgekehrte Leiste (53) an den Enden zu bilden, und wobei der Niederhaltefinger eine ausgewählte der ersten Leiste und der umgekehrten Leiste überlappt, um den Unterteil in einer ersten, nicht umgekehrten Position oder in einer zweiten, umgekehrten Position anzuordnen.

2. Haltevorrichtung nach Anspruch 1 für einen elektrischen Verbinder mit einem gestapelten Paar der Gehäuse und der Führungsarme, deren Kanäle (51) zueinander ausgerichtet sind, um eine einzige solche Haltevorrichtung aufzunehmen, wobei die Vorsprünge an der Haltevorrichtung in Seiten von entsprechenden ausgerichteten Kanälen der gestapelten Gehäuse und Führungsarme zum Eingriff bringbar sind.

## Revendications

1. Equerre de montage pour un connecteur électrique (1) comprenant un boîtier (2), une embouchure (3) de réception de carte dans le boîtier, des contacts électriques (4) portés par le boîtier jusque dans l'embouchure, des douilles (26) de réception de griffes sur le boîtier, des bras de guidage (5, 6) sur des côtés opposés de l'embouchure, une gorge (22) de réception de carte sur chacun des bras de guidage, une griffe (25) sur chacun des bras de guidage réalisée pour réaliser un engagement de verrouillage avec les douilles, caractérisée en ce que l'équerre (41) de montage peut être engagée dans une rainure choisie (51) dans le boîtier et les bras de guidage et comporte au moins un bras (44, 45) faisant saillie d'une base (42), qui permet une connexion à une plaquette à circuit, des saillies (50) sur le bras ou l'un des bras, et un doigt (49) de maintien s'étendant latéralement dans le plan du bras ou de l'un des bras, l'équerre de montage pouvant être glissée dans la rainure choisie de façon que les saillies rappellent le bras ou les bras contre des côtés opposés (54) de la rainure, la rainure étant élargie à des extrémités opposées (52) pour former un premier rebord (53) et un second rebord retourné (53) aux extrémités, respectivement, et le doigt de maintien chevauchant l'un, choisi, du premier rebord et du rebord retourné pour positionner la base dans une première position non retournée ou dans une seconde position, retournée.

2. Equerre de montage selon la revendication 1, pour un connecteur électrique comportant une paire superposée des boîtiers et des bras de guidage dont des rainures (51) sont alignées pour recevoir une telle et unique équerre de montage, les saillies situées sur l'équerre de montage pouvant être engagées dans des côtés de rainures alignées respectives des boîtiers superposés et des bras de guidage.
